# EUROPEAN PATENT APPLICATION

(11) **EP 0 996 324 A1**
(43) Date of publication of application: **26.04.2000**
(21) Application number: 98308542.4
(22) Date of filing: 19.10.1998
(51) Int. Cl.: H05K 5/06, H02G 3/08

(54) **Single lock seal**

(71) Applicant: LUCENT TECHNOLOGIES INC., Murray Hill, New Jersey 07974-0636 (US)
(72) Inventor: Henzen, Theo Hendrikus Wilhelmus, 3891 DD Zeewolde (NL); Prins, Ernest Johan, 3941 CE Doorn (NL)
(74) Representative: Williams, David John

(57) **Abstract**

There is disclosed a lid (4) for a housing, wherein the housing comprises a lip (16) for making contact with a lip (14) of the lid when closed, a rubber seal being provided between the lip of the housing and the lip of the lid, wherein the lid is provided with a lock (6) for engagement with the housing and the lid is formed of a material having elastic deformation such that the lip of the lid compresses the rubber seal against the lip of the housing when the lock is engaged.

## Description

### Field Of the Invention

The invention relates to a housing in which a mechanism to ensure sealing of the closure parts of the housing from an external environment is provided. The invention relates particularly, but not exclusively, to such housings for electronic circuitry.

### Background to the Invention

Housings that provide an environmental seal for the closure parts of the housing are well known. Typically such housings include a main body with a hinged lid. The lid closes onto a rubber seal around the lip of the main body housing, the rubber seal providing a seal between the lid and the housing which seals the inside of the housing from the external environment.

To ensure integrity of the seal, it is necessary to provide a number of locking mechanisms on the lid which ensure that the lid firmly presses the rubber seal against the body of the housing. A number of locking mechanisms are necessary since it is required that the rubber seal is under some degree of compression at all points between the lid and the body of the housing to ensure the necessary environmental seal. The provision of a number of locks provides a number of compression points spaced around the rubber seal, which ensure integrity of the seal.

The provision of a plurality of locks increases the complexity of the manufacturing of the housing, and complicates access to the housing during maintenance.

In order to ensure integrity of the seal, it is also necessary for both the lid and body of the housing to be carefully machined. Any deficiency in the tolerances in machining the edges of the lid and body of the main housing which compress the seal may result in the seal not being properly compressed. With conventional housings careful machining of the housing is thus essential to ensure integrity of the environmental seal.

In such conventional arrangements, it is further necessary to stiffen the lid of the housing by an additional stiffening process during manufacture. Stiffening of the lid ensures that it maintains its shape. If the lid were to lose its shape by deforming under the compression of the rubber seal, then the integrity of the environmental seal may be adversely affected since the shape of the lid will no longer guarantee the appropriate pressure being applied. Any deformation of the lid is undesirable.

It is therefore an object of the present invention to provide a housing that provides an improved environmental seal.

### Summary of the Invention

According to the present invention there is provided a lid for a housing, wherein the housing comprises a lip for making contact with a lip of the lid when closed, a rubber seal being provided between the lip of the housing and the lip of the lid, wherein the lid is provided with a lock for engagement with the housing and the lid is formed of a material having elastic deformation such that the lip of the lid compresses the rubber seal against the lip of the housing when the lock is engaged.

The improved environmental seal minimises the requirements of machining and manufacturing, and consequently minimises the time and cost of manufacturing, minimises the access time to the housing during maintenance, and increases the life span of the housing.

The lid may be provided with a hinge on one side connected to the housing, the lock mechanism being provided on the opposite side of the lid for engagement with the opposite side of the housing.

The lock may be provided in the centre of the one side of the lid.

End stops may be provided between the lip of the housing and the lip of the lid to provide a reaction force against the force of the locking mechanism. The end stops may be provided proximate to the extreme ends of the one side of the housing. The end stops may be adjustable.

The locking mechanism may be adjustable.

### Brief Description of the Drawings

Figure 1 shows a view of a conventional sealed housing;
Figure 2 shows a view of a sealed housing according to the present invention; and
Figure 3 shows a view illustrating the sealing mechanism of the housing of Figure 1.

### Description of Preferred Embodiment

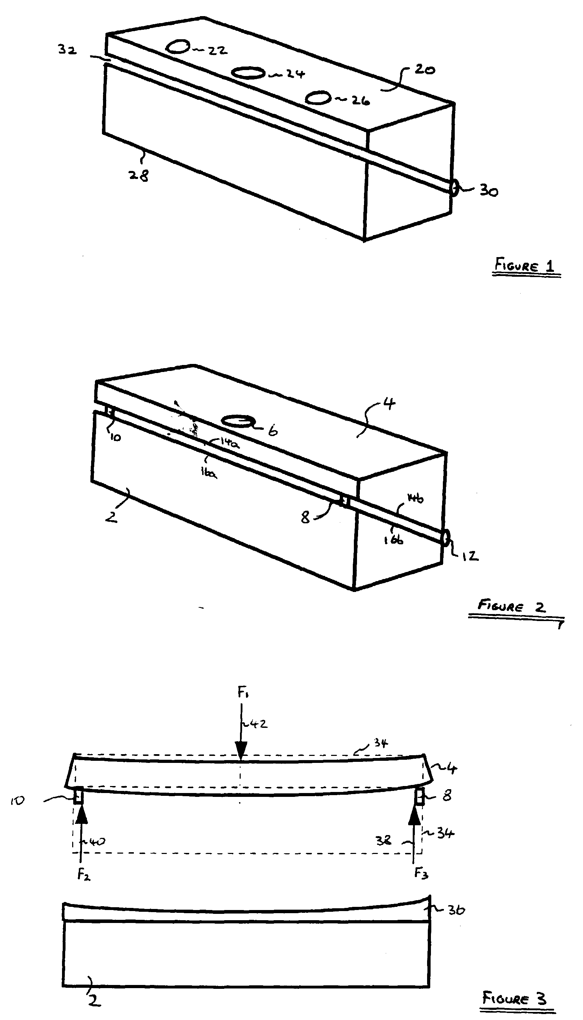

Referring to Figure 1 there is shown a conventional box or housing which will now be briefly described. The housing comprises a body or frame 28, a lid or cover 20, a hinge 30, and three locking mechanisms generally designated by reference numerals 22, 24 and 26.

As is seen in Figure 1, in the closed position there is a gap, generally designated by reference numeral 32, between the lid and the body. In this gap 32 there is provided a rubber seal which is compressed by the hinged lid 20 closing on the body 28. In the closed position of the lid 20, each of the locking mechanisms 22, 24 and 26 provided on the lid engage with respective engagement means provided inside the body. The engagement of the locking mechanisms on the lid with the body provides a compression force on the rubber seal, against the body, which ensures an environmentally tight seal on the housing. It will be appreciated that the rubber seal must be under some degree of compression all around the boundary between the lid and the body in the gap 32. Any deficiencies in this respect will adversely affect the integrity of the environmental seal.

To ensure integrity of the environmental seal in this conventional arrangement, there are three essential requirements:
1. Provision of multiple locks. Multiple locks are essential to ensure that the compression force is guaranteed all around the rubber seal. The multiple locks all provide a downward force on the rubber seal. If there was only a single lock, say lock 24, then at the extremities of the lid there will not be sufficient force to sufficiently compress the rubber seal. The weakened force at the extremities may also cause the housing to be more vulnerable to external environmental forces, such as wind, forcing up the extremities of the lid.
2. Provision of carefully machined housing. Both the lid 20 and the body 28 must be carefully machined in order to ensure accurate forming of the respective edges which make contact with the rubber seal in the gap 32. Any deformities in these edges will reduce the compression force on the rubber seal and adversely affect the environmental seal.
3. Provision of strengthened lid. The lid 20 must be strengthened or reinforced by extra processes during manufacturing. If the lid 20 is not strengthened, then the downward force of the locking mechanisms (22, 24, 26 in Figure 1) may attract opposite, resistive forces when the rubber seal is compressed, causing the lid to deform and thereby causing the integrity of the environmental seal to be adversely affected.

It should also be noted that in this conventional arrangement once the rubber seal starts to wear and erode, through use, there will come a point were the integrity of the environmental seal can no longer be guaranteed. In addition general maintenance of the housing is difficult in the conventional arrangement of Figure 1 because of the time required to open multiple locks. In such conventional housings, it is also quite often necessary to provide a further overall locking mechanism to satisfy customers of the integrity of the environmental seal.

Referring to Figure 2 there is shown a box or housing according to the present invention. The housing comprises a body or frame 2 and a lid or cover 4. The lid 4 is connected to the body 2 by a hinge 12, one end of which is visible in Figure 1. The hinge 12 is connected to the body 2 and the lid 4 all along the long edge of the box which is not visible in Figure 1. The hinge 12 provides an environmental seal along that edge when the lid is closed on the body.

As can be seen in Figure 2, the lid 4 is provided with a lip 14 around the other three sides thereof. The other long side of the lid 4 has a lip 14a and the short side of the lid 4 visible in Figure 1 is provided with a lip 14b. The other short side of the lid 4 is not visible in Figure 1, but it will be appreciated that it too will have a lip similar to the lip 14b.

As can also be seen from Figure 2, the body 2 is provided with a lip 16 around the three sides thereof not connected to the hinge 12. The other long side of the body 2 has a lip 16a and the short side of the body visible in Figure 1 is provided with lip 16b. The other short side of the body is not visible in Figure 1, but it will be appreciated that it too will have a lip similar to the lip 16b.

The lid 4 is provided with a lock mechanism 6 that engages with an engagement means in the body of the housing to lock the lid to the body. The details of the lock mechanism do not form part of the present invention, and one skilled in the art will appreciate that this lock mechanism may be implemented in a number of ways. The top of the lock mechanism 6 is visible on the lid 4 in Figure 1. The lock mechanism will extend below the lid 4 and engage, when the lid is closed, with engaging means provided inside the body 2.

Although not shown in Figure 2 so as not to obscure the detail of the Figure, the assembled housing is provided with a rubber seal between the lip 14 of the lid and the lip 16 of the body. Thus when the lid 4 is closed on the body 2 the lips 14 and 16 both engage a respective side of the rubber seal. The rubber seal is typically glued to the frame.

In accordance with one embodiment of the invention, end-stops 8 and 10 are provided. The end-stops may be attached either to the lid 4 or the body 2, but are preferably attached to the body 2. The end-stops 8 and 10 are provided proximate to the extreme ends of the side of the housing to which the lock mechanism is attached. As will be described further hereinbelow, the end-stops operate advantageously with the present invention.

The operation of the invention will now be described with reference to Figure 3 in combination with Figure 2, which both illustrate the preferred embodiment of the invention including the end-stops 8 and 10. In Figure 3 there is shown the body 2 of the housing having a rubber seal attached thereto. The lid 4 is also represented. The dashed lines 34 represent the shape of the lid and the body prior to application of the locking force of the locking mechanism 6. Although the lid 4 and the body 2 with rubber seal 36 are shown spaced apart, this is for eases of understanding and in fact in the drawing of Figure 3 the lid 4 and body 2 of the housing are shown after the locking mechanism 6 has been engaged on closure of the lid

The end-stops 8 and 10 are shown in Figure 3, but the locking mechanism 6 is not shown for reasons of clarity. The presence of the locking mechanism is shown by the arrow 42 which represents the downward force F₁ created by the locking mechanism on the rubber seal. The end-stop 10 provides an opposite, upward force F₂, represented by the arrow 40, on the rubber seal. Similarly the end-stop 8 provides an opposite, upward force F₃ represented by arrow 38.

As can be seen from Figure 3, the effect of the downward force F₁ and the opposite forces F₂ and F₃ is to deform the lid 4 to compress the rubber seal 36 into the shape shown in Figure 3.

The rubber seal 36 is in its uncompressed shape, in which it is shown pre-formed. The lid 4 may itself be pre-formed, and the rubber seal be presented flat.

The elastic deformation of the lid is used to apply a guaranteed minimum load on the hard end-stops 8 and 10. The minimum load is calculated such that it is impossible to lift the cover from the end stops due to mechanical forces caused by vibrations and vacuums, which could arise under external environmental conditions such as wind. The elastic deformation of the cover is compensated for rubber seal thickness.

The maximum elastic deformation of the lid 4 occurs when there is no rubber seal 36 between the body and the lid at the point of application of the Force F₁. During the lifetime of the rubber the compression force on the rubber seal 36 will decrease slowly. The elasticity of the lid 4 will follow the rubber seal. This will compensate for the rubber deterioration in time.

Many tolerances in the design are eliminated because the hard end stops are also a reference for machining of the closed surfaces.

The end stops are preferably adjustable. This means that adjusting the height of the end stops can compensate for the die casting process tolerances and rubber thickness tolerances. The lock may also be made adjustable, whether or not he end-stops are provided, eliminating the need for additional machining.

As described hereinabove elastic deformation of the lid 4 is desirable as it has actual functional use. Additional stiffening of the lid, as in the conventional arrangement, is therefore not required. This saves space in the lid which improves thermal design and provides the ability to house additional electronics.

It will be appreciated that the end-stops 8 and 10 are not essential to the present invention. If the rubber seal is provided with a formed shape as shown in Figure 3, then the compression force of the locking mechanism will cause the central portion of the rubber seal 36 to compress. The resistance of the extreme ends of the rubber seal will create an opposite force having an affect similar to that created by the end-stops.

It will also be appreciated that the principles of the present invention would still apply to providing an improved environmental seal even if the locking mechanism was provided in a position other than that shown in Figures 2 and 3. Due to the elasticity of the lid, the seal will still be provided even if the lock is positioned off-centre on the side of the lid or even in the centre of the lid.

The housing may typically contain circuits such as: electrical line-cards, powers supply, batteries, copper/optical multiplexer, lightning protectors, EMC filters, cabling and connectors, and optical splice and cassettes. The housing particularly provides environmental protection to electronics contained within.

## Claims

1. A lid (4) for a housing, wherein the housing comprises a lip (16) for making contact with a lip (14) of the lid when closed, a rubber seal being provided between the lip of the housing and the lip of the lid, wherein the lid is provided with a lock (6) for engagement with the housing and the lid is formed of a material having elastic deformation such that the lip of the lid compresses the rubber seal against the lip of the housing when the lock is engaged.

2. The lid of claim 1 wherein the lid is provided with a hinge (12) on one side connected to the housing, the lock mechanism being provided on the opposite side of the lid for engagement with the opposite side of the housing.

3. The lid of claim 2 wherein the lock is provided in the centre of the one side of the lid.

4. The lid of any preceding claim, in which end stops (8, 10) are provided between the lip of the housing and the lip of the lid to provide a reaction force against the force of the locking mechanism.

5. The lid of claim 4 in which the end stops are provided proximate to the extreme ends of the one side of the housing.

6. The lid of Claim 4 in which the end stops are adjustable.

7. The lid of any preceding claim in which the locking mechanism is adjustable.
